Europäisches Patentamt

European Patent Office

Office européen des brevets

(19)

(11) Veröffentlichungsnummer: **0 226 893 B1**

(12) **EUROPÄISCHE PATENTSCHRIFT**

(45) Veröffentlichungstag der Patentschrift:
05.06.91 Patentblatt 91/23

(51) Int. Cl.$^5$: **G03B 41/00**, G01B 11/02

(21) Anmeldenummer: 86116741.9

(22) Anmeldetag: 02.12.86

(54) **Verfahren zur hochgenauen Positionsvermessung von zweidimensionalen Strukturen und Referenzmaske zur Durchführung des Verfahrens.**

(30) Priorität: 13.12.85 DE 3544224

(43) Veröffentlichungstag der Anmeldung:
01.07.87 Patentblatt 87/27

(45) Bekanntmachung des Hinweises auf die
Patenterteilung:
05.06.91 Patentblatt 91/23

(84) Benannte Vertragsstaaten:
CH DE FR GB LI NL SE

(56) Entgegenhaltungen:
EP-A- 0 005 462
EP-A- 0 105 711
EP-A- 0 155 138
FR-A- 2 385 103
GB-A- 2 075 182

(73) Patentinhaber: Siemens Aktiengesellschaft
Wittelsbacherplatz 2
W-8000 München 2 (DE)

(72) Erfinder: Doemens, Günter, Dr.
Föchinger Strasse 4
W-8150 Holzkirchen (DE)
Erfinder: Eigenstetter, Herbert
Alex.-Fleming-Strasse 107
W-8033 Planegg (DE)
Erfinder: Mengel, Peter, Dr.
Roggensteinerallee 32
W-801 Eichenau (DE)

## Beschreibung

Die Erfindung betrifft ein Verfahren zur hochgenauen Positionsvermessung von zweidimensionalen Strukturen, insbesondere von Meßstrukturen auf Wafern oder Masken, sowie eine Referenzmaske zur Durchführung dieses Verfahrens.

Bei der Herstellung integrierter Halbleiterschaltungen erfolgt der Aufbau der Bauelemente und Strukturen von einer Oberfläche einer aus einem Siliziumkristall bestehenden Halbleiterscheibe, dem sog. Wafer, her. Der Siliziumkristall dient dabei sowohl als Träger der gesamten Schaltung wie als Halbleiterwerkstoff für die aktiven Bauelemente wie Transistoren und dgl.. Die im Halbleiter notwendigen unterschiedlichen Dotierungen werden von der Oberfläche der Halbleiterscheibe her eingebracht, und zwar entweder durch die Difussionstechnik oder durch die Ionenimplantationstechnik. Meist sind mehrere Dotierungsschritte nacheinander in verschiedenen Strukturen notwendig. Es folgen dann die Verbindungs-und Anschlußleitungen, die auf mit Fenstern versehenen Oxidschichten verlegt werden, auch sie meist in mehreren Strukturlagen übereinander. Die Übertragung der nacheinander herzustellenden Strukturen auf die Halbleiterscheibe erfolgt auf photolithografischem Wege, wobei bei jedem Strukturierungsvorgang die Halbleiterscheibe mit einem Fotoresist beschichtet und dann dieses Fotoresist über eine Maske mit der entsprechenden Struktur belichtet und dann entwickelt wird. Bei immer kleiner werdenden Strukturdimensionen und immer größer werdenden Wafern kommt der Deckungsgenauigkeit der in verschiedenen Phototechnikebenen auf dem Wafer nacheinander zu erzeugenden Strukturen eine immer größere Bedeutung zu. Die Ursachen von Deckungsfehlern der nacheinander photolithografisch auf die Halbleiterscheibe zu übertragenden Strukturen liegen dabei bei der Justierung aufeinanderfolgenden Masken zu dem Wafer sowie in Streuungen der Positionen der einzelnen Strukturelemente im Wafer und in der Maske. Derartige Streuungen können auf systematische Fehler der verwendeten Belichtungseinrichtung, auf einen Verzug von Wafer oder Maske bei der Durchführung chemischer Prozeße oder auf andere Ursachen die zu einem Verzug von Maske oder Wafer führen zurück geführt werden.

Aus der DE-C-2 822 269 bzw. der EP-A-0 005 462 ist ein Verfahren zur automatischen Maskenjustierung bekannt, bei welchem die Justierung aufeinanderfolgender Masken jeweils mit orthogonal zueinander verlaufenden Justierstrukturen auf dem mit einem Photoresist beschichteten Wafer und auf der Maske vorgenommen wird. Die Justierstruktur des Wafers wird bereits im ersten Strukturierungsvorgang auf der Oberfläche des Wafers beispielsweise durch Ätzen erzeugt, so daß bei sämtlichen nachfolgenden Strukturierungsvorgängen die auf der entsprechenden Maske vorhandenen Justierstrukturen in Bezug auf diese erste Justierstruktur ausgerichtet werden können. Zur automatischen Maskenjustierung werden dann die Justierstrukturen auf Maske und Wafer in parallel zu ihren Kanten verlaufenden Richtungen mit Hilfe eines Bildwandlers optoelektronisch abgetastet, worauf die Intensität der durch die optoelektronische Abtastung erzeugten Bildsignale zeilenweise oder zeilenabschnittsweise aufintegriert wird und die daraus resultierenden analogen Integralwerte in digitale Graustufen umgewandelt und gespeichert werden. Durch Differenzbildung der Graustufen aufeinanderfolgender Zeilen und weitere Auswertung der resultierenden Differenzsignale kann dann die Lage der Mittelachsen der Justierstrukturen erfaßt werden, worauf dann Wafer und Maske zur Justierung entsprechend dem festgestellten Versatz der Mittellinie gegeneinander verschoben werden. Zum Einsatz kommen hierbei transparente Träger, die, beispielweise mit einem zweidimensionalen Gitter versehen, als Masken eingesetzt werden.

Im Hinblick auf das Problem der Streuung der Positionen der einzelnen Strukturelemente im Wafer und in der Maske wurden bisher absolute Positionsvermessungen durch spezielle Meßmaschinen durchgeführt, wobei die Objektkanten photoelektrisch erfäßt und der Abstand durch Verfahren der Maske bzw. des Wafers über Laserinterferometer bestimmt wurde. Diese Anordnung verlangt höchste Präzision der Mechanik, eine schwingungsarme und temperaturstabile Umgebung sowie eine regelmäßige Kalibrierung der Laserinterferometer durch entsprechende normale. Insgesamt erfordert die Installation einer solchen Meßmöglichkeit sehr hohe Investitionen, wobei die auf Dauer erzielbare Meßsicherheit von der Qualität der regelmäßigen Kalibrierung bestimmt wird.

Aus dem Aufsatz "Metrology in Mask Manufacturing" in IBM J, Res. Develop., Vol. 26, No. 5, September 1982, Seiten 553 bis 560 ist auch bereits ein Verfahren zur Ermittlung von Deckungsfehlern der Strukturen auf Wafer und Maske bekannt, bei welchem die Positionsvermessung mit Hilfe von quadratischen Meßstrukturen auf Maske und Wafer vorgenommen wird. Diese quadratischen Meßstrukturen sind auf der Maske und auf dem Wafer jeweils verschieden groß, so daß die Mittenabweichungen ineinandergeschachtelter Quadrate örtliche Deckungsfehler anzeigen. Absolute Positionsvermessungen von zweidimensionalen Strukturen auf Maske oder Wafer sind mit diesem bekannten Verfahren jedoch nicht möglich.

Aus der DRUCKSCHRIFT FR-A-2 385 103 ist es bekannt, die Emittlung der absoluten Position von zu vermessenden Strukturen über die Identifizierung von einzelnen Zellen und deren Positionen relativ zum gesamten Gitter zu bestimmen.

Der Erfindung liegt die Aufgabe zugrunde, ein Verfahren zur hochgenauen Positionsvermessung von zwei-

EP 0 226 893 B1

dimensionalen Strukturen, insbesondere von Meßstrukturen auf Wafern oder Masken, zu schaffen, bei welchem die Qualität der Messungen verbessert, der apparative Aufwand deutlich verringert und der Meßvorgang rationalisiert wird.

Diese Aufgabe wird erfindungsgemäß durch die kennzeichnenden Merkmale des Anspruchs 1 gelöst.

Der Erfindung liegt die Erkenntnis zugrunde, daß das Problem der Vermessung kleinster Strukturen mit Strukturabmessungen von beispielsweise 0,1 µm über relativ große Wege von beispielsweise 100 mm durch direkte Vergleichsmessungen zu einem Normal gelöst werden kann, wobei auf zu vermessende Wafer oder Masken Meßstrukturen aufgebracht werden, die aus Elementen bestehen, die gegenseitig um eine halbe Gitterperiode versetzt sind und die gleiche Periode aufweisen wie das zweidimensionale Gitter. Hierdurch kann mit Sicherheit ausgeschlossen werden, daß eine Lageerkennung der Meßstrukturen durch die Gitterstruktur gestört wird. Hierzu wird über den zu vermessenden Strukturen eine Referenzmaske angeordnet, auf deren transparenten Träger sich das zweidimensionale Gitter befindet. Die Relativlage der zu vermessenden Strukturen zu benachbarten Gitterelementen des zweidimensionalen Gitters wird dann durch optoelektronische Abtastung mit Hilfe eines Bildwandlers und anschließende Bildverarbeitung ermittelt, wobei hierzu beispielsweise die aus der DE-C-2 822 269 bekannten Bildverarbeitungseinrichtungen eingesetzt werden können. Die Absolutposition der zu vermessenden Strukturen zum zweidimensionalen Gitter wird dann aus der gemessenen Relativlage zu benachbarten Gitterelementen und der vorgegebenen Lage dieser Gitterelemente im zweidimensionalen Gitter ermittelt. Die problematischen größeren Wege werden also nicht direkt sondern über die bekannten Abmessungen der Gitterstruktur ermittelt.

Als wesentliche Vorteile des erfindungsgemäßen Verfahrens sind insbesondere eine geringere systematische Meßunsicherheit, eine höhere Zuverlässigkeit durch weitgehende Unabhängigkeit von Temperaturschwankungen, Schwingungen sowie Kalibrierungen, der Wegfall mechanisch bewegter Teile und der einfache und kostengünstige Aufbau der erforderlichen Meßanordnung zu nennen.

Gemäß einer bevorzugten Ausgestaltung des erfindungsgemßen Verfahrens ist vorgesehen, daß durch Vorstellung des Objektivs eines Midroskops des zweidimenionale Gitter und die vermessenden Strukturen jeweils scharf auf dem Bildwandler abgebildet werden. Durch die eindeutig scharfe Abbildung der jeweiligen Strukturen auf dem Bildwandler wird die erzielbare Genauigkeit der Positionsvermessung weiter erhöht. Eine hierzu geeignete Einrichtung zur optischen Abbildung zweier in verschiedenen Objektebenen angeordneter Objekte ist in der älteren europäischen Patentanmeldung Nr. 85.115.482.3 (EP-A-0 185 263) beschrieben.

Die vorgegebene Lage der Gitterelemente im zeidimensionalen Gitter wird vorzugsweise durch eine Codierung der einzelnen Gitterelemente ermittelt, welche durch die Bildverarbeitung automatisch gelesen und decodiert wird. Durch diese Codierung kann ein Abzählen der einzelnen Gitterelemente oder eine Vermessung des Gitters durch gröbere Meßverfahren entfallen, wobei durch die eindeutige Lagenangabe der einzelnen Gitterelemente die Meßsicherheit weiter erhöht wird.

Zur Durchführung des erfindungsgemäßen Verfahrens wird vorzugsweise eine Referenzmaske verwendet, bei welcher auf einem transparenten Träger ein zweidimensionales Gitter aufgebracht ist, wobei die Lage der einzelnen Gitterelemente im Gitter durch eine darauf aufgebrachte Codierung erfaßbar ist. Vorzugsweise sind dabei auf die Gitterelemente binäre Codierungen aufgebracht, die durch die bekannten Bildverarbeitungseinrichtungen besonders leicht lesbar sind. Die binäre Codierung wird hierbei durch Rauten gebildet, deren Diagonalen parallel zu den Kanten der Gitterelemente verlaufen. Die Kanten der Rauten verlaufen also nicht parallel zu den Kanten der Gitterelemente, so daß ein störender Einfluß der Codierung auf die mit hoher Präzision durchzuführende Lageerkennung der Kanten der Gitterelemente mit Sicherheit ausgeschlossen werden kann.

Eine weitere Steigerung der erzielbaren Meßgenauigkeit wird dadurch erreicht, daß der Träger aus Glaskeramik besteht. Ein derartiger als Glaskeramik bestehender Träger der Referenzmaske zeichnet sich durch besonders geringe thermische Ausdehungskoeffizienten aus. Schließlich hat es sich auch noch als vorteilhaft herausgestellt, wenn das zweidimensionale Gitter durch eine auf den Träger aufgebrachte Chromschicht gebildet ist.

Ein Ausführungsbeispiel der Erfindung ist in der Zeichnung dargestellt und wird im folgenden näher beschrieben.

Es zeigen :

Fig. 1 in stark vereinfachter schematischer Darstellung eine Anordnung zur hochgenauen Positionsvermessung von Meßstrukturen auf Wafern oder Masken,

Fig. 2 eine mit der Anordnung nach Fig. 1 erfaßte Meßstruktur auf einer Maske,

Fig. 3 die in Fig. 2 dargestellte Meßstruktur in bezug auf das zweidimensionale Gitter einer Referenzmaske,

Fig. 4 das Prinzip der Positionsvermessung mit einer Referenzmaske, deren Gitterelemente mit einer Codierung versehen sind und

Fig. 5 Einzelheiten der in Fig. 4 dargestellten Referenzmaske.

3

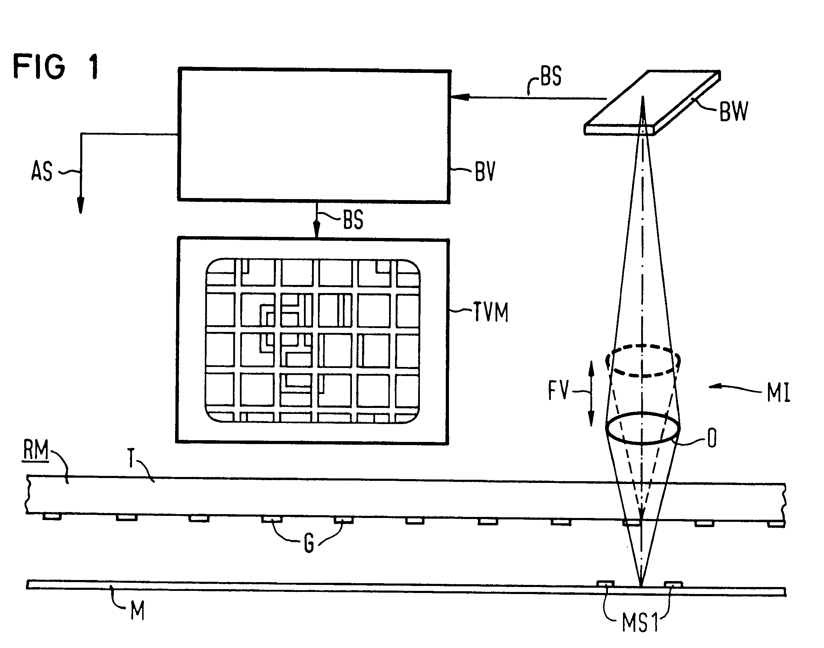

Fig. 1 zeigt eine Anordnung zur hochgenauen Positionsvermessung von Meßstrukturen MS1, die sich neben den auf einen Wafer zu übertragenden Strukturen auf einer Maske M befinden. In einem geringen Abstand von beispielsweise 20 µm wird oberhalb der Maske M eine insgesamt mit RM bezeichnete Referenzmaske angeordnet, die aus einem Träger T und einem darauf aufgebrachten zweidimensionalen Gitter G besteht. Als Träger T dient eine Glaskeramik mit einem geringen thermischen Ausdehnungskoeffizienten, während das zweidimensionale Gitter G durch eine dünne Chromschicht gebildet wird.

Die Kanten der Meßstrukturen MS1 und die Kanten des zweidimensionalen Gitters G werden mit Hilfe eines Bildwandlers BW optoelektronisch abgetastet, wobei es sich bei den Bildwandler BW um eine CCD-Kamera mit 403 × 512 Bildelementen handelt. Für die Abbildung der Meßstrukturen MS1 und des zweidimensionalen Gitters G auf dem Bildwandler BW ist ein Mikroskop MI vorgesehen, dessen Objektiv O durch ein Autofokussystem auf die jeweilige Strukturebene scharfgestellt wird, wobei die entsprechende Fokusverstellung durch einen Pfeil FV aufgezeigt ist. Ein hierzu geeignetes Mikroskop dessen Objektiv relativ zu verschiedenen Objektebenen absolut schiftfrei und mit einer sehr hohen Positionierwiederholbarkeit verstellt werden kann, ist in der älteren europäischen Patentanmeldung Nr. 85 115 482.3 (EP-A-0 185 263) beschrieben.

Das von dem Bildwandler BW erzeugte Bildsignal BS wird einer Bildverarbeitung BV und einem TV-Monitor TVM zugeführt, auf dessen Bildschirm eine Meßstruktur MS1 und ein Bereich des zweidimensionalen Gitters G zu erkennen sind. Das mit AS bezeichnete Ausgangssignal der Bildverarbeitung BV liefert eventuell vorhandene Lageabweichungen $\Delta$ Yi und $\Delta$ Xi der Meßstrukturen MS1 an entsprechenden Stellen Xi, Yi der Maske M.

Die Meßstruktur MS1 auf der Maske M und die Strukturen des zweidimensionalen Gitters G auf der Referenzmaske RM werden in zwei zueinander senkrechten und parallel zu ihren Kanten verlaufenden Richtungen mit Hilfe des Bildwandlers BW abgetastet, worauf die Intensität der durch die optoelektronische Abtastung erzeugten Bildsignale BS in der Bildverarbeitung BV zeilenweise oder zeilenabschnittsweise aufintegriert wird und die daraus resultierenden analogen Integralwerte in digitale Graustufen umgewandelt und gespeichert werden. Durch Differenzbildung der Graustufen aufeinanderfolgender Zeilen und weitere Auswertung der resultierenden Differenzsignale kann dann die Lage der einzelnen Strukturen erfaßt und die Relativlage der jeweiligen Meßstruktur MS1 zum Gitter G automatisch bestimmt werden. Weitere Einzelheiten über eine derartige Grauwertbildverarbeitung mit zeilenweiser Integration und anschließender Symmetriebetrachtung gehen beispielsweise aus der DE-C-28 22 269 hervor.

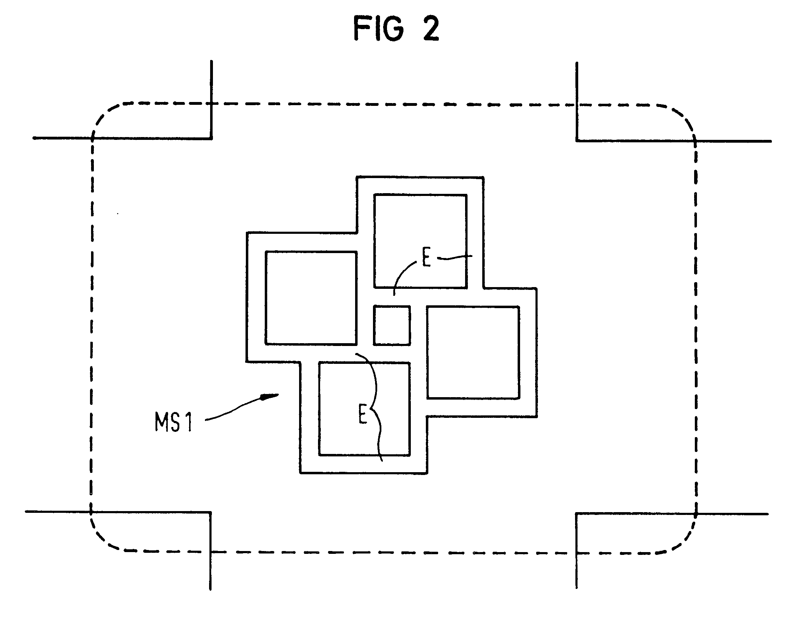

Fig. 2 zeigt die Meßstruktur MS1 in der Draufsicht. Es ist zu erkennen, daß die einzelnen Elemente E der Meßstruktur MS1 in beiden Richtungen derart versetzt zueinander angeordnet sind, daß eine Übereinstimmung mit der Gitterperiode des Gitters G (vergl. Fig. 1) mit Sicherheit ausgeschlossen werden kann. Dabei ist es besonders günstig, wenn die Elemente E um eine halbe Gitterperiode versetzt sind und die gleiche Periode aufweisen wie das zweidimensionale Gitter G.

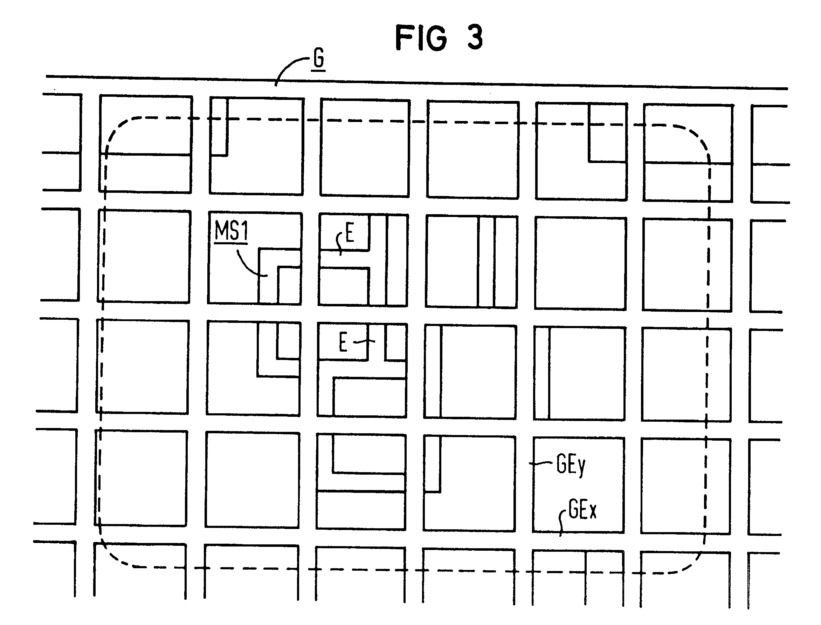

Fig. 3 zeigt die in Fig. 2 dargestellte Meßstruktur MS1 zusammen mit dem zweidimensionalen Gitter G. Es ist zu erkennen, daß die Elemente E der Meßstruktur MS1 und die Gitterelemente GEx und GEy des Gitters G optoelektronisch abgetastet und in ihrer Lage automatisch erfaßt werden können, ohne sich gegenseitig zu stören oder zu behindern. Somit kann auch die Relativlage zwischen einer Meßstruktur MS1 und den benachbarten Gitterelementen GEx und GEy des Gitters G problemlos ermittelt werden.

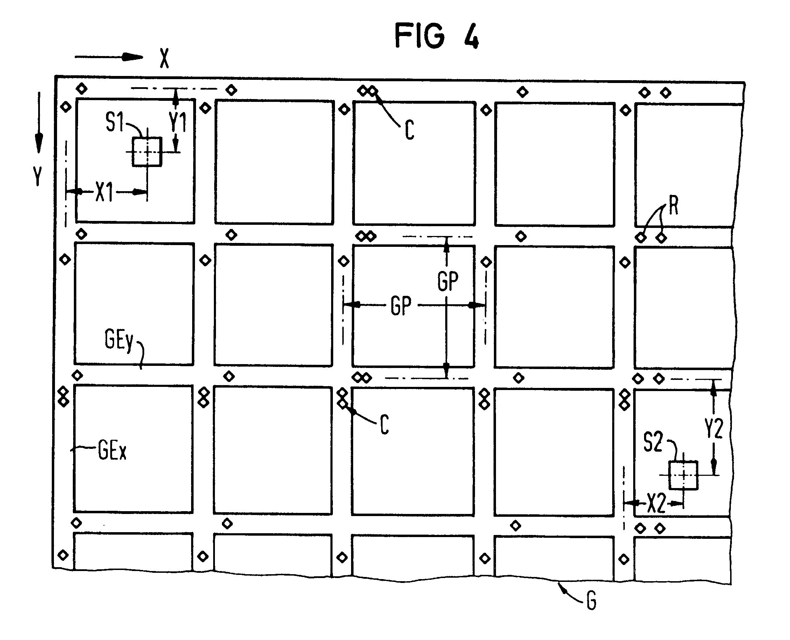

Die Fig. 4 zeigt das Prinzip der Positionsvermessung von zweidimensionalen Strukturen mit Hilfe des Gitters G der Referenzmaske RM (vergl. Fig. 1). Anstelle der in Fig. 2 dargestellten Meßstruktur MS1 sind hier zwei im Abstand zueinander angeordnete Strukturen S1 und S2 dargestellt, die zur Vereinfachung der Darstellung lediglich als Quadrate ausgebildet sind. Die Gitterelemente GEx und GEy des Gitters G verlaufen parallel zu der Achse eines X, Y-Koordinatensystems.

Durch optoelektronische Abtastung und nachfolgende Bildverarbeitung werden zunächst die Abstände X1 und Y1 des Mittelpunktes der Struktur S1 zu der Mittellinie des links davon liegenden Gitterelements GEx bzw. des darüberliegenden Gitterelements GEy ermittelt. Auf entsprechende Weise werden dann die Abstände X2 und Y2 des Mittelpunkts der Struktur S2 zu der Mittellinie des links davon liegenden Gitterelements GEx bzw. des darüber liegenden Gitterelements GEy ermittelt. Werden die Abstände der Mittelpunkte der Strukturen S1 und S2 in X-Richtung mit $\Delta$ X und Y-Richtung mit $\Delta$ Y bezeichnet, so gilt für den in Fig. 4 dargestellten Fall

$$\Delta X = X2 - X1 + 4GP$$

$$\Delta Y = Y2 - Y1 + 2GP$$

wobei GP die Gitterperiode des quadratischen Gitters G in der X-Richtung und in der Y-Richtung ist.

In Wirklichkeit umfaßt das in Fig. 4 dargestellte Gitter G beispielsweise

$$2^{12} \times 2^{12} = 16.777.216$$

quadratische Zellen, so daß anstelle von 4GP oder 2GP in der Praxis eine sehr große Anzahl von Gitterperioden GP zu berücksichtigen ist. Die Ermittlung der jeweils zu berücksichtigenden Anzahl von Gitterperioden GP kann dann auf besonders einfache Weise durch optoelektronische Abtastung und die nachgeordnete Bildverarbeitung BV (vergl. Fig. 1) vorgenommen werden, wenn jedes Gitterelement GEx und GEy mit einer binären Codierung C versehen ist, die seine Lage im Gitter G angibt.

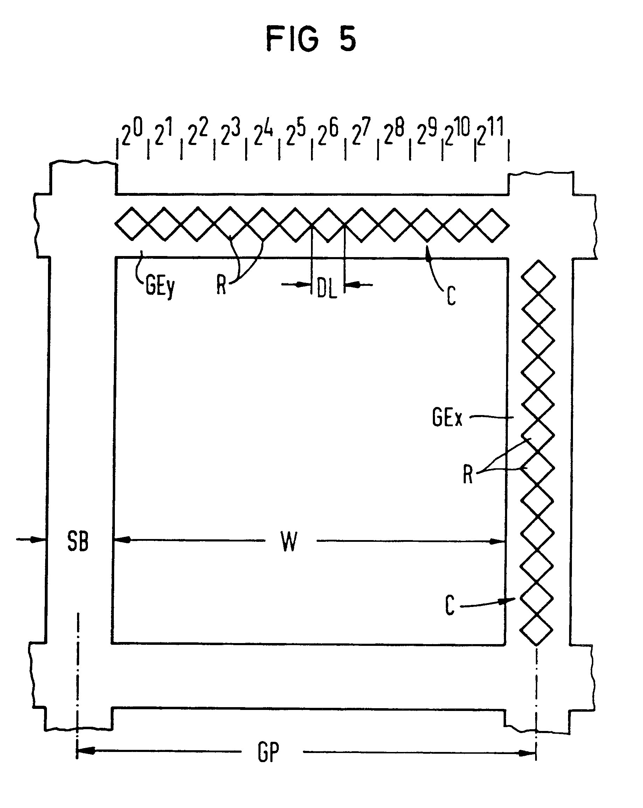

Zur weiteren Erläuterung der Codierung C wird zusätzlich auf die Fig. 5 verwiesen. Jedes Gitterelement GEx und GEy kann durch die Codierungen C identifiziert werden, wobei die Codierungen C als Rauten R ausgebildet sind. Gemäß Fig. 5 ist auf jedem Gitterelement GEx bzw. GEy Platz für insgesamt 12 Rauten R vorhanden, deren nicht dargestellte Diagonalen parallel zu den Kanten der Gitterelemente GEx und GEy verlaufen. Im übrigen sind die vorhandenen Rauten R optisch transparent, so daß sie als Codierung C durch die optoelektronische Abtastung und die nachfolgende Bildverarbeitung BV (vergl. Fig. 1) gelesen und decodiert werden können. Jede Raute R gibt je nach ihrer Lage einen der Werte zwischen $2^0$ und $2^{11}$ an.

Bei der in Fig. 4 dargestellten Gitterzelle in welcher die Struktur S1 liegt, ergeben die Codierungen C in beiden Richtungen $2^0 = 1$, d.h. die Zelle trägt die Nummer 1,1. Bei der Gitterzelle, in welcher die Struktur S2 liegt, ergeben die Codierungen C in X-Richtung $2^0 + 2^2 = 5$ und in Y-Richtung $2^0 + 2^1 = 3$, d.h. die Zelle trägt die Nr. 5,3. Gemäß der Differenz der Zellennummern sind dann bei der bereits angegebenen Ermittlung von $\Delta X$ und $\Delta Y$ die Werte (5-1) GP bzw. (3-1) GP zu berücksichtigen.

Bei der in Fig. 5 dargestellten Gitterzelle sind neben der Gitterperiode GP die Lichte Weite W der Gitterzelle, die Stegbreite SB eines Gitterelements GEx oder GEy und die diagonale Länge DL einer Raute R eingezeichnet.

Bei dem dargestellten Ausführungsbeispiels wurden folgende Abmessungen verwirklicht :

$$GP = 28\ \mu m$$

$$W = 24\ \mu m$$

$$SB = 4\ \mu m$$

$$DL = 2\ \mu m$$

Das erfindungsgemäße Verfahren hat insbesondere den Vorteil, daß über relativ große Weglängen von beispielsweise 100 µm hochgenaue Messungen von Strukturen im Submikrometerbereich ermöglicht werden. Dies ist darauf zurückzuführen, daß die hochgenauen Messungen nur im Nahbereich der Strukturen durchgeführt werden und sich die restlichen Wegstrecken ebenfalls sehr präzise aus der Codierung des Gitters ergeben.

Bezugszeichenliste

| AS | Ausgangssignal |
|---|---|
| BS | Bildsignal |
| BV | Bildverarbeitung |
| BW | Bildwandler |
| C | binäre Codierung |
| DL | diagonale Länge einer Raute |
| E | Element der Meßstruktur |
| FV | Fokusverstellung |
| G | Gitter |
| GEx | Gitterelement |
| GEy | Gitterelement |
| GP | Gitterperiode |
| M | Maske |
| MI | Mikroskop |
| MS1 | Meßstruktur |
| O | Objektiv |
| R | Raute |
| RM | Referenzmaske |

| | |
|---|---|
| S1, S2 | Struktur |
| T | Träger |
| TVM | TV-Monitor |
| W | lichte Weite der Gitterzelle |
| X1, X2 | Koordinate |
| Y1, Y2 | Koordinate |

## Ansprüche

1. Verfahren zur Bestimmung der Position von zweidimensionalen Strukturen auf Wafern oder Masken bezüglich einer Referenzmaske mit folgenden Merkmalen :
– unmittelbar über den Strukturen (S1, S2) wird die Referenzmaske (RM) angeordnet, auf deren transparentem Träger (T) sich ein zweidimensionales Gitter (G) befindet,
– die Relativlage der Strukturen (S1, S2) zu benachbarten Gitterelementen (GEx, GEy) des zweidimensionalen Gitters (G) wird durch optoelektronische Abtastung mit Hilfe eines Bildwandlers (BW) und anschliessende Bildverarbeitung (BV) ermittelt, dadurch gekennzeichnet, daß
– auf die zu vermessenden Wafer oder Masken (M) zusätzlich Meßstrukturen (MS1) aufgebracht werden, die aus Elementen (E) bestehen, die gegenseitig um eine halbe Gitterperiode versetzt sind und die gleiche Periode aufweisen wie das zweidimensionale Gitter (G), und
– die Absolutposition der Meßstrukturen (MS1) im zweidimensionalen Gitter (G) aus der Relativlage dieser Meßstrukturen zu benachbarten Gitterelementen (GEx, GEy) und der vorgegebenen Lage dieser Gitterelemente (GEx, GEy) im zweidimensionalen Gitter (G) ermittelt wird.

2. Verfahren nach Anspruch 1, **dadurch gekennzeichnet,** daß durch Verstellung des Objektivs (O) eines Mikroskops (MI) das zweidimensionale Gitter (G) und die zu vermessenden Strukturen (S1, S2 ; MS) jeweils scharf auf den Bildwandler (BW) abgebildet werden.

3. Verfahren nach Anspruch 1 oder 2, **dadurch gekennzeichnet,** daß die vorgegebene Lage der Gitterelemente (GEx, GEy) im zweidimensionalen Gitter (G) durch eine Codierung (C) der einzelnen Gitterelemente (GEx, GEy) ermittelt wird, welche durch die Bildverarbeiung (BV) automatisch gelesen und decodiert wird.

4. Referenzmaske zur Verwendung bei dem Verfahren nach Anspruch 3 mit einem transparenten Träger (T) sowie einem auf diesem aufgebrachtem zweidimensionalen Gitter (G) aus undurchsichtigen Gitterstegen dadurch gekennzeichnet daß die Gitterstege jeweils eine die Lage der Gitterelemente (GEx, GEy) bestimmende und meßtechnisch erfaßbare binäre Codierung in Form von auf den Stegen aufgebrachten Rauten (R) tragen, deren Diagonalen parallel zu den Kanten der Gitterelemente (GEx, GEy) verlaufen.

5. Referenzmaske nach Anspruch 4, **dadurch gekennzeichnet,** daß der Träger (T) aus Glaskeramik besteht.

6. Referenzmaske nach einem der Ansprüche 4 oder 5, **dadurch gekennzeichnet,** daß das zweidimenionale Gitter (G) durch eine auf dem Träger (T) aufgebrachte Chromschicht gebildet ist.

## Claims

1. Method for determining the position of two-dimensional structures on wafers or masks in relation to a reference mask having the following features :
– the reference mask (RM) is arranged directly over the structures (S1, S2) and a two-dimensional grid (G) is located on the transparent carrier (T) of said mask,
– the relative position of the structures (S1, S2) with respect to adjacent grid elements (GEx, GEy) of the two-dimensional grid (G) is determined by means of opto-electronic scanning with the aid of an image sensor (BW) and subsequent image processing means (BV),
characterised in that
– additionally applied to the wafers or masks (M) to be measured are measuring structures (MS1) consisting of elements (E) which are mutually offset by one half of a grid period and have the same period as the two-dimensional grid (G), and
– the absolute position of the measuring structures (MS1) in the two-dimensional grid (G) is determined from the relative position of these measuring structures with respect to adjacent grid elements (GEx, GEy) and the predetermined position of these grid elements (GEx, GEy) in the two-dimensional grid (G).

2. Method according to Claim 1, characterised in that the two-dimensional grid (G) and the structures (S1, S2 ; MS) to be measured are in each case sharply focused on the image sensor (BW) by adjusting the objective (O) of a microscope (MI).

3. Method according to Claim 1 or 2, characterised in that the predetermined position of the grid elements (GEx, GEy) in the two-dimensional grid (G) is determined by a coding (C) of the individual grid elements (GEx, GEy) which is automatically read and decoded by the image processing means (BV).

4. Reference mask for use in the method according to Claim 3 having a transparent carrier (T) and also a twodimensional grid (G) made of non-transparent grid strips applied thereto, characterised in that the grid strips carry in each case a binary coding, which specifies the position of the grid elements (GEx, GEy) and can be sensed by means of metrology, in the form rhomboids (R) which are applied to the strips and whose diagonals extend parallel to the edges of the grid elements (GEx, GEy).

5. Reference mask according to one of Claim 4, characterised in that the carrier (T) is made of glass ceramic.

6. Reference mask according to one of Claims 4 or 5, characterised in that the two-dimensional grid (G) is formed by a chromium layer applied to the carrier (T).


## Revendications

1. Procédé pour déterminer la position de structures bidimensionnelles sur des pastilles ou des masques par rapport à un masque de référence, présentant les caractéristiques suivantes :
   – on dispose, directement au-dessus des structures (S1, S2), le masque de référence, sur le support transparent (T) duquel est située une grille bidimensionnelle (G),
   – on détermine la position relative des structures (S1, S2) par rapport à des éléments voisins (GEx, GEy) de la grille bidimensionnelle (G) au moyen d'une exploration optoélectronique, réalisée à l'aide d'un convertisseur d'images (BW), et d'un traitement ultérieur (BV) de l'image,
   caractérisé par le fait que
   – on dépose, en outre, sur les pastilles ou les masques (M) à mesurer, des structures de mesure (MS1), qui sont constituées d'éléments (E) décalés réciproquement d'un demi-pas de la grille bidimensionnelle (G) et possédant le même pas que cette grille, et
   – on détermine la position absolue des structures de mesure (MS1) dans la grille bidimensionnelle (G) à partir de la position relative de ces structures de mesure par rapport à des éléments voisins (GEx, GEy) de la grille bidimensionnelle (G), et de la position prédéterminée de ces éléments (GEx, GEy) de cette grille.

2. Procédé suivant la revendication 1, caractérisé par le fait qu'en déplaçant l'objectif (O) d'un microscope (MI), on forme une image nette de la grille bidirectionnelle (G) et des structures (S1, S2 ; MS) à mesurer, sur le convertisseur d'images (BW).

3. Procédé suivant la revendication 1 ou 2, caractérisé par le fait qu'on détermine la position prédéterminée des éléments (GEx, GEy) de la grille bidimensionnelle (G) au moyen d'un codage (C) des différents éléments (GEx, GEy) de la grille, qui sont lus et décodés automatiquement lors du traitement (BV) de l'image.

4. Masque de référence destiné à être utilisé dans le procédé suivant la revendication 3, comportant un support transparent (T) ainsi qu'une grille bidimensionnelle (G) disposée sur ce support et formée par des barreaux opaques, caractérisé par le fait que les barreaux de la grille portent respectivement un codage binaire, qui détermine la position des éléments (GEx, GEy) de la grille, peut être détecté selon une technique de mesure et se présente sous la forme de losanges (R) placés sur les barreaux et dont les diagonales sont parallèles aux côtés des éléments (GEx, GEy) de la grille.

5. Masque de référence suivant la revendication 4, caractérisé par le fait que le support (T) est constitué par un vitrocérame.

6. Masque de référence suivant l'une des revendications 4 ou 5, caractérisé par le fait que la grille bidimensionnelle (G) est formée par une couche de chrome déposée sur le support (T).

FIG 1

FIG 2

# FIG 3

# FIG 4

EP 0 226 893 B1

# FIG 5